# NEUE EUROPÄISCHE PATENTSCHRIFT

(11) **EP 1 006 211 B2**
(45) Veröffentlichungstag und Bekanntmachung des Hinweises auf die Entscheidung über den Einspruch: **16.03.2011**
(45) Hinweis auf die Patenterteilung: 08.12.2004
(21) Anmeldenummer: 99810972.2
(22) Anmeldetag: 27.10.1999
(51) Int. Cl.: C23C 14/54, C23C 14/02, C23C 4/12

(54) **Verfahren und Einrichtung zur Plasma-Oberflächenbehandlung von Substraten**
Method and apparatus for plasma treatment of substrates
Procédé et appareil de traitement de substrats par plasma

(30) Priorität: 02.12.1998 CH 239598
(43) Veröffentlichungstag der Anmeldung: 07.06.2000
(73) Patentinhaber: Sulzer Metco AG, 5610 Wohlen (CH)
(72) Erfinder: Keller, Silvano, 5315 Böttstein (CH)
(74) Vertreter: Sulzer Management AG

(56) Entgegenhaltungen:
- EP-A- 0 248 117
- EP-A2- 0 248 117
- EP-A2- 0 477 990
- DD-A- 291 783
- DD-A5- 291 783
- DE-A1- 2 812 271
- DE-A1- 4 427 259
- DE-C- 4 135 326
- DE-C1- 4 135 326
- DE-C1- 4 228 499
- GB-A- 1 447 754
- GB-A- 2 178 227
- JP-A- 07 305 158
- JP-A- 62 012 693
- US-A- 4 090 941
- US-A- 4 116 791
- US-A- 4 500 564
- PATENT ABSTRACTS OF JAPAN vol. 011, no. 192 (C-429), 19. Juni 1987 (1987-06-19) & JP 62 012693 A (NISSIN ELECTRIC CO LTD), 21. Januar 1987 (1987-01-21)
- PATENT ABSTRACTS OF JAPAN vol. 096, no. 003, 29. März 1996 (1996-03-29) & JP 07 305158 A (NIPPON STEEL CORP), 21. November 1995 (1995-11-21)
- Technische Spezifikation "Elektronenstrahl-Springstrahlanlage, Typ ESPRI 150", von Ardenne Anlagentechnik GmbH, 12.11.1993, Dresden
- Auszug aus "Wikipedia" http://de.wikipedia.org/wiki/Tron vom 15.05.2006
- Auszug aus "Wikipedia" http://de.wikipedia.org/wiki/Lichtbogen vom 12.10.2007

## Beschreibung

Um eine möglichst gute Qualität der mittels einer Plasmaspritzvorrichtung auf ein Substrat aufgetragenen Schicht zu erhalten, muss einerseits die Oberfläche des Substrats sauber sein und zum anderen muss das Substrat auf eine bestimmte Temperatur erhitzt werden. Beide Faktoren tragen dazu bei, eine gute Bindung zwischen dem Substrat und der aufgetragenen Schicht zu gewährleisten.

Das Plasma-Beschichten von Substraten findet im Normalfall in einer Behandlungskammer statt, in welcher zumeist ein Unterdruck erzeugt wird, damit die Oxidationsgefahr weitgehend gebannt ist. Bei bekannten Verfahren wird das zu beschichtende Substrat in die eigentliche Behandlungskammer eingeführt, in der es zuerst gereinigt, dann erhitzt und anschliessend beschichtet wird. Somit hängt die Behandlungszeit des Substrats nicht allein von der für den eigentlichen Beschichtungsvorgang benötigten Zeit ab, sondern sie wird durch das Reinigen und Erhitzen des Substrats massgeblich verlängert. Vorrichtungen zum Aufbringen von Schichten sind beispielsweise in der DE 41 35 326, der JP 62 012 693 und der DD 291 783 offenbart.

Es ist daher die Aufgabe der Erfindung ein Verfahren sowie eine Einrichtung zur Plasma-Oberflächenbehandlung von Substraten vorzuschlagen, mittels welchem bzw. welcher der Durchsatz massgeblich gesteigert werden kann, wobei die Qualität der aufgetragenen Schicht qualitativ hohen Anforderungen genügen soll.

Diese Aufgabe wird durch die im Kennzeichen des Anspruchs 1 angeführten Verfahrensschritte bzw. die im Kennzeichen des Anspruchs 9 aufgeführten Merkmale gelöst.

Indem das zeitintensive, dem eigentlichen Beschichtungsvorgang vorangehende Vorbehandeln des Substrats ausserhalb der Behandlungskammer durchgeführt wird, kann in der Behandlungskammer ein Substrat plasmabeschichtet werden, währenddem zeitgleich ein nachfolgend zu beschichtendes Substrat ausserhalb der Behandlungskammer vorbehandelt werden kann. Dadurch kann die Verweilzeit des Substrats in der Behandlungskammer verkürzt und der Durchsatz erhöht werden. Unter zeitgleich ist zu verstehen, dass sich der Beschichtungsvorgang und das Vorbehandeln zeitlich zumindest teilweise überlappen. Zeitgleich ist jedoch keinesfalls so zu interpretieren, dass beide Vorgänge gleich lange dauern müssen oder dass die beiden Vorgänge zum gleichen Zeitpunkt gestartet oder beendet werden müssen.

Erfahrungswerte zeigen, dass die zum Vorbehandeln (Reinigen und Erhitzen) des Substrats benötigte Zeit ca. dem 0.5 bis 2-fachen der eigentlichen Beschichtungszeit entspricht. Das heisst mit anderen Worten, dass durch ein ausserhalb der Behandlungskammer durchgeführtes Vorbehandeln des Substrats der Durchsatz um ca. 50 bis 100% erhöht werden kann.

Bevorzugte Verfahrensschritte sind in den abhängigen Ansprüchen 2 bis 11 umschrieben, währenddem bevorzugte Weiterbildungen der Einrichtung in den abhängigen Ansprüchen 13 bis 21 definiert sind.

Anhand von Zeichnungen wird nachfolgend eine bevorzugte Variante des erfindungsgemässen Verfahrens sowie eine bevorzugte Ausführungsform der erfindungsgemässen Einrichtung näher erläutert. In diesen Zeichnungen zeigt:
Fig. 1 die Einrichtung während einer ersten Prozess-Phase;
Fig. 2 die Einrichtung während einer zweiten Prozess-Phase;
Fig. 3 die Einrichtung während einer dritten Prozess-Phase;
Fig. 4 die Einrichtung während einer vierten Prozess-Phase, und
Fig. 5 die Einrichtung während einer fünften Prozess-Phase.

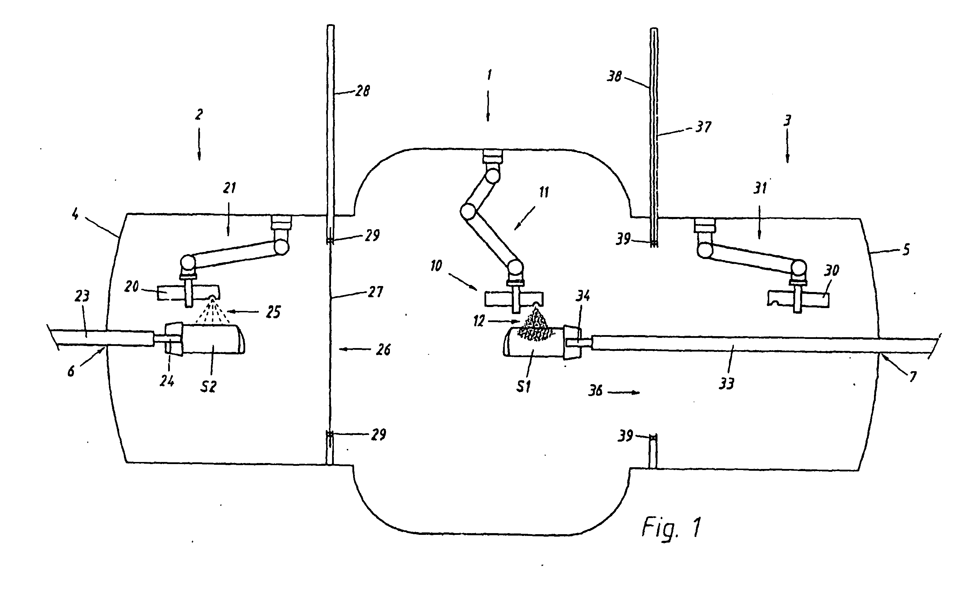

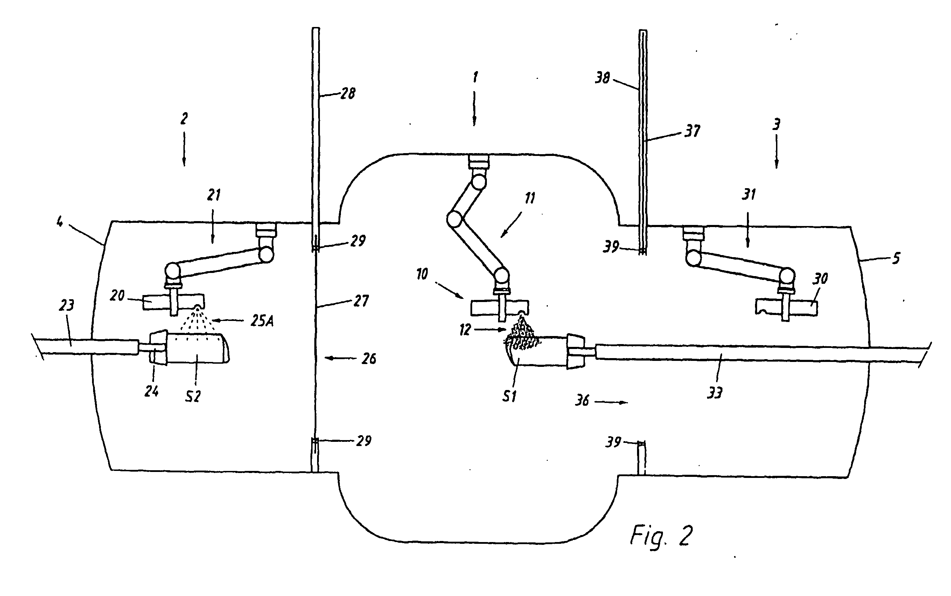

Anhand der Figuren 1 und 2, welche die Einrichtung während zwei verschiedenen Prozess-Phasen zeigen, soll der grundsätzliche Aufbau der Einrichtung näher erläutert werden. Da das grundsätzliche Prinzip des Vorbehandelns und Beschichtens von Substraten mittels eines Plasmatrons bekannt ist, wird nur auf die im Zusammenhang mit der Erfindung wesentlichen Merkmale eingegangen. Im vorliegenden Beispiel wird zudem davon ausgegangen, dass die einer Plasma-Oberflächenbehandlung zu unterziehenden Substrate aus Metall bestehen.

Die Einrichtung weist eine zentrale Behandlungskammer 1 auf, in der eine Plasmaspritzvorrichtung 10 aufgenommen ist. Die Plasmaspritzvorrichtung 10 ist an einem in drei Ebenen beweglichen Schwenkmechanismus 11 angeordnet. Auf beiden Seiten der Behandlungskammer 1 ist je eine Vorkammer 2, 3 angeordnet, welche seitlich mit je einem abhebbaren Deckel 4, 5 versehen ist. Bei abgehobenem Deckel 4, 5 kann das jeweilige Substrat S1, S2 der Vorkammer 2, 3 zugeführt bzw. aus dieser entnommen werden.

Beide Vorkammern 2, 3 sind mit je einem Plasmatron 20, 30 versehen. Jedes Plasmatron 20, 30 ist an einem Schwenkmechanismus 21, 31 befestigt. Jeder Vorkammer 2, 3 ist eine Haltevorrichtung 23, 33 zugeordnet, welche zur Aufnahme eines Substrats S1, S2 ausgebildet ist. Am Ende der jeweiligen Haltevorrichtung 23, 33 ist eine Spannvorrichtung 24, 34 angeordnet, mittels welcher das Substrat S1, S2 festgespannt werden kann. Jeder Deckel 4, 5 ist mit einer Öffnung 6, 7 zum Durchführen der Haltevorrichtung 23, 33 versehen. Die Haltevorrichtungen 23, 33 sind in Längsrichtung soweit bewegbar, dass das jeweilige Substrat S1, S2 ausserhalb der Vorkammer 2, 3 in die Haltevorrichtung 23, 33 bzw. die Spannvorrichtung 24, 34 eingespannt und von der Haltevorrichtung 23, 33 in die Behandlungskammer 1 überführt werden kann. Die Haltevorrichtungen 23, 33 sind zudem um ihre Längsachse drehbar, so dass zum Zwecke einer gleichmässigen Vorbehandlung bzw. Beschichtung das Substrat S1, S2 sowohl während des Vorbehandelns wie auch während des Beschichtens in die jeweils optimale Position gedreht werden kann.

Zwischen der Behandlungskammer 1 und den beiden Vorkammern 2, 3 ist je ein Schieber 27, 37 vorgesehen, mittels welchem die Behandlungskammer 1 gegenüber der jeweiligen Vorkammer 2, 3 dicht abschliessbar ist. Die im wesentlichen rund ausgebildeten Schieber 27, 37 sind in je einer Aufnahme 28, 38 geführt. In den Fig. 1 und 2 ist jeweils der die linke Vorkammer 2 von der Behandlungskammer 1 abtrennende Schieber 27 geschlossen. Um einen Gasaustausch zwischen der aktiven Vorkammer 2 und der Behandlungskammer 1 bzw. zwischen den jeweiligen Vorkammern 2, 3 und der freien Atmosphäre zu verhindern, sind die Schieberaufnahmen 28, 38 mit Dichtungen 29, 39 versehen. Es versteht sich, dass auch im Bereich der beiden Deckel 4, 5 Dichtungen vorgesehen sind, welche jedoch zugunsten einer übersichtlichen Darstellung nicht eingezeichnet sind.

Zum Evakuieren der Behandlungskammer 1 sowie der beiden Vorkammern 2, 3 ist eine Vakuumanlage vorgesehen, welche zugunsten einer übersichtlichen Darstellung jedoch ebenfalls nicht eingezeichnet ist. Da derartige Vakuumanlagen zudem bekannt sind, erübrigt es sich, an dieser Stelle näher darauf einzugehen.

Die Funktionsweise der Einrichtung wird nachfolgend anhand der Fig. 1 bis 5 näher erläutert. Bei der in Fig. 1 dargestellten ersten Phase ist der Schieber 37 zwischen der rechten Vorkammer 3 und der Behandlungskammer 1 geöffnet, währenddem der Schieber 27 zwischen der linken Vorkammer 2 und der Behandlungskammer 1 geschlossen ist. Dadurch kann in der linken Vorkammer 2 sowie in der Behandlungskammer 1 zusammen mit der rechten Vorkammer 3 eine auf den jeweiligen Prozess abgestimmte Atmosphäre geschaffen und eine gegenseitige Beeinflussung des jeweiligen Vorgangs vermieden werden. Im vorliegenden Fall herrscht sowohl in der linken Vorkammer 2 wie auch in der Behandlungskammer 1 ein Unterdruck in der Grössenordnung von ca. 10 bis 50 mbar.

Das in der Haltevorrichtung 33 eingespannte erste Substrat S1 wird in der Behandlungskammer 1 mittels der Plasmaspritzvorrichtung 10 beschichtet. Der aus der Beschichtungsvorrichtung 10 austretende Beschichtungsstrahl trägt das Bezugszeichen 12. Gleichzeitig mit dem Beschichten des ersten Substrats S1 wird in der linken Vorkammer 2 ein zweites Substrat S2 mittels des Plasmatrons 20 vorbehandelt. Unter Vorbehandeln wird im vorliegenden Fall ein Reinigen und Erhitzen verstanden, wobei in Fig. 1 das Erwärmen des Substrats S2 mittels einer Plasmaflamme 25 und in Fig. 2 das Reinigen durch einen vom Plasmatron auf das Substrat übertragenen Lichtbogen 25A schematisch dargestellt ist. Indem das Substrat S2 als Kathode geschaltet und ein zwischen dem Plasmatron 20 und dem Substrat S2 übertragener Lichtbogen 25A erzeugt wird, wird ein Elektronenfluss vom zweiten Substrat S2 zum Plasmatron 20 bewirkt, so dass die Oberfläche des Substrats S2 von Verunreinigungen und Oxyden befreit wird. Dieser Prozess ist dem Fachmann unter dem Begriff "sputtering" bekannt. Für bestimmte Anwendungsfälle ist es vorteilhaft, wenn das Substrat S2 wechselweise einem Reinigungs- und einem Erhitzungsprozess unterzogen wird. Es versteht sich, dass das sich in der Behandlungskammer 1 befindliche erste Substrat S1 vor dem Plasma-Beschichten ebenfalls in der vorerwähnten Weise gereinigt und erhitzt wurde.

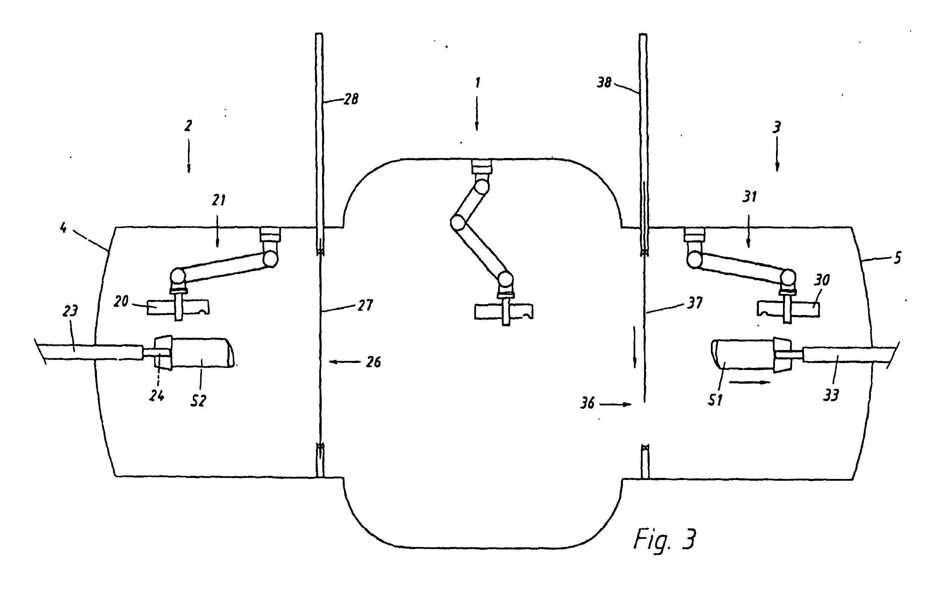

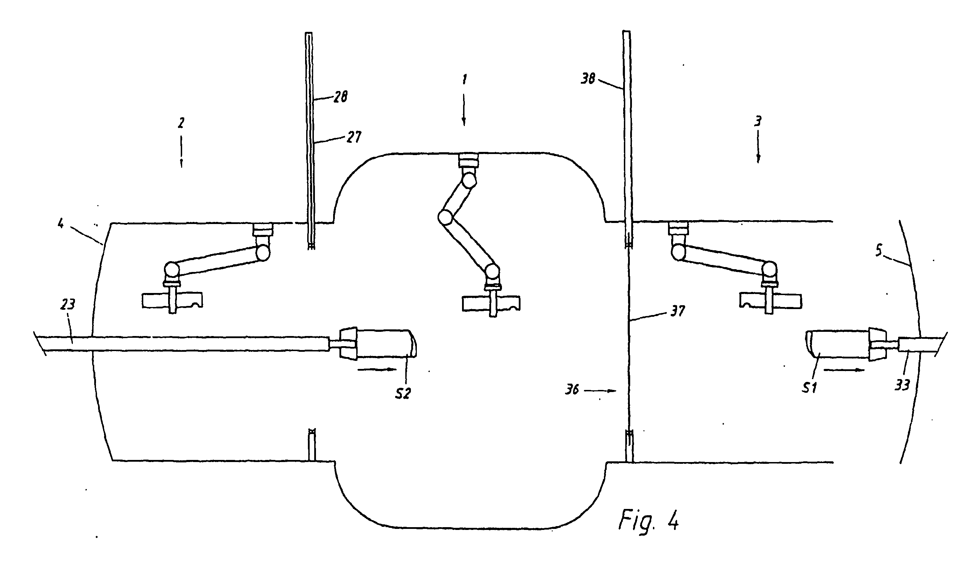

Nachdem das erste Substrat S1 beschichtet und das zweite Substrat S2 gereinigt und erhitzt wurde, wird die Haltevorrichtung 33 nach rechts verschoben. Sobald sich das Substrat S1 in der rechten Vorkammer befindet, wird der Schieber 37 geschlossen (Fig. 3) und danach der Schieber 27 geöffnet. Um den Deckel 5 der rechten Vorkammer 3 abheben und das fertig beschichtete Substrat S1 entnehmen zu können, wird der Druck in der rechten Vorkammer 3 bis auf den Atmosphärendruck erhöht. Nach dem Abheben des Deckels 5 wird die Haltevorrichtung 33 soweit nach rechts verschoben, dass das fertig beschichtete Substrat S1 aus der Spannvorrichtung 34 ausgespannt und durch ein neues ersetzt werden kann (Fig. 4). Gleichzeitig kann nun das zweite Substrat S2 von der linken Vorkammer 2 in die Behandlungskammer 1 überführt werden. Nachdem die Haltevorrichtung 33 zusammen mit einem neuen Substrat wieder in die rechte Vorkammer 3 hineinbewegt wurde, kann der Deckel 5 geschlossen die rechte Vorkammer 3 wiederum evakuiert werden.

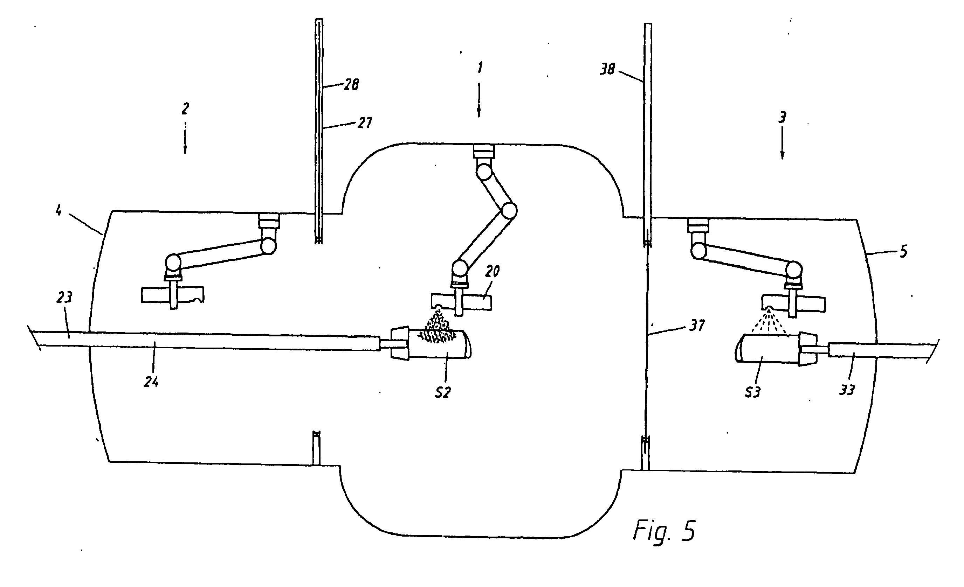

Danach kann das in der Behandlungskammer 1 aufgenommene Substrat S2 wiederum mittels der Plasmaspritzvorrichtung 10 beschichtet werden, währenddem in der rechten Vorkammer 2 gleichzeitig das weitere Substrat S3 mittels des Plasmatrons 30 in der vorerwähnten Art vorbehandelt wird (Fig. 5).

Indem sowohl die Vorkammern 2, 3 wie auch die Behandlungskammer 1 evakuierbar sind, kann das Substrat nach dem Vorbehandeln von der Vorkammer in die Behandlungskammer überführt werden, ohne dass die Gefahr eines Oxydierens der gereinigten Substratoberfläche besteht.

Es versteht sich, dass das vorgängige Beispiel lediglich eine mögliche Variante des erfindungsgemässen Verfahrens zusammen mit einer bevorzugte Ausführungsform der erfindungsgemässen Einrichtung umschreibt, und dass im Rahmen des in den Patentansprüchen definierten Schutzumfangs durchaus von vorgängigem Beispiel abweichende Ausführungsformen des Verfahrens sowie der Einrichtung möglich sind. Beispielsweise wäre es denkbar, anstelle von zwei Vorkammern mem auch deren drei vorzusehen. Auch die Art und Anordnung der Haltevorrichtungen kann durchaus anders gewählt werden.

## Patentansprüche

1. Verfahren zur Plasma-Oberflächenbehandlung von Substraten, **gekennzeichnet durch** folgenden Verfahrensablauf:
- ein erstes Substrat (S1) wird in einer Behandlungskammer (1) plasmabeschichtet während gleichzeitig ein nachfolgend zu beschichtendes zweites Substrat (S2) in einer ersten Vorkammer (2) mittels eines ersten Plasmatrons (20) erhitzt und gereinigt wird, wobei das Plasmatron während dem Erhitzen und Reinigen bewegt wird;
- das erste Substrat (S1) wird danach aus der Behandlungskammer (1) entfernt und das zweite Substrat (S2) in die Behandlungskammer (1) überführt und darin mittels einer Plasmaspritzvorrichtung (10) plasmabeschichtet;
- während des Beschichtens des zweiten Substrats (S2) in der Behandlungskammer (1) wird gleichzeitig ein drittes Substrat (S3) in einer zweiten Vorkammer (3) mittels eines weiteren Plasmatrons (30) erhitzt und gereinigt, wobei das Plasmatron während dem Erhitzen und Reinigen bewegt wird.

2. Verfahren nach Anspruch 1, **dadurch gekennzeichnet, dass** das zweite Substrat (S2) zur Reinigung als Kathode geschaltet und ein vom Plasmatron (20) auf das Substrat (S2) übertragener Lichtbogen (25A) erzeugt wird.

3. Verfahren nach einem der vorhergehenden Ansprüche, **dadurch gekennzeichnet, dass** in der Behandlungskammer (1) zumindest während des Plasmabeschichtens eines Substrats (S1) ein Unterdruck erzeugt wird.

4. Verfahren nach einem der vorhergehenden Ansprüche, **dadurch gekennzeichnet, dass** in der Vorkammer (2) zumindest während des Vorbehandelns eines Substrats (S2) ein Unterdruck erzeugt wird.

5. Verfahren nach einem der vorhergehenden Ansprüche, **dadurch gekennzeichnet, dass** nacheinander zu beschichtende Substrate (S2, S3) wechselweise in einer ersten bzw. zweiten Vorkammer (2, 3) vorbehandelt werden.

6. Verfahren nach einem der vorangehenden Ansprüche, **dadurch gekennzeichnet, dass** die jeweilige Vorkammer (2, 3) während des Vorbehandelns eines Substrats (2, 3) sowohl gegenüber der Umgebungsatmospäre wie auch gegenüber der Behandlungskammer (1) abgeschlossen wird.

7. Verfahren nach einem der vorhergehenden Ansprüche, **dadurch gekennzeichnet, dass** das Substrat (S2, S3) während des Vorbehandelns bewegt wird/werden.

8. Verfahren nach einem der vorhergehenden Ansprüche, **dadurch gekennzeichnet, dass** das Substrat (S1) und/oder das Plasmatron (10) während des Plasmabeschichtens bewegt wird/werden.

9. Einrichtung zur Durchführung des Verfahrens nach einem der vorangehenden Ansprüche, mit einer evakuierbaren Behandlungskammer (1) mit einer darin angeordneten Plasmaspritzvorrichtung (10) sowie zwei Vorkammern (2, 3) zum Vorbehandeln eines der Behandlungskammer (1) nachfolgend zuzuführenden Substrats (S1, S2), **dadurch gekennzeichnet, dass** zwei an die Behandlungskammer (1) angrenzende Vorkammern (2, 3) vorgesehen sind, welche über je eine verschliessbare Öffnung (26, 36) mit der Behandlungskammer (1) verbunden sind, dass in jeder Vorkammer (2, 3) ein beweglich angeordnetes Plasmatron (20, 30) zum Vorbehandeln des in der Behandlungskammer (1) nachfolgend zu beschichtenden Substrats (S1, S2) vorgesehen ist, und dass jeder Vorkammer (2, 3) eine Haltevorrichtung (23, 33) zum Einspannen eines Substrats (S1, S2) zugeordnet ist.

10. Einrichtung nach Anspruch 9, **dadurch gekennzeichnet, dass** jeder Vorkammer (2, 3) ein Schieber (27, 37) zum Verschliessen der Öffnung (26, 36) zugeordnet ist.

11. Einrichtung nach einem der Ansprüche 9 oder 10, **dadurch gekennzeichnet, dass** jede Vorkammer (2, 3) mit einem abnehmbaren Deckel (4, 5) versehen ist, wobei jeder Deckel (4, 5) mit einer Öffnung (6, 7) zum Durchführen der Haltevorrichtung (23, 33) versehen ist.

12. Einrichtung nach einem der Ansprüche 9 bis 11, **dadurch gekennzeichnet, dass** die Haltevorrichtung(en) (23, 33) in Längsrichtung bewegbar ausgebildet ist/sind, und dass die jeweilige Haltevorrichtung (23, 33) um zumindest die Länge einer Vorkammer (2, 3) bewegbar ist.

13. Einrichtung nach einem der Ansprüche 9 bis 12, **dadurch gekennzeichnet, dass** jede Haltevorrichtung (23, 33) endseitig mit einer Spannvorrichtung (24, 34) versehen ist.

14. Einrichtung nach Anspruch 13, **dadurch gekennzeichnet, dass** zumindest die Spannvorrichtung (24, 34) drehbar ausgebildet ist.

15. Einrichtung nach einem der Ansprüche 9 bis 14, **dadurch gekennzeichnet, dass** die Vorkammern (2, 3) einander diametral gegenüberliegen.

16. Einrichtung nach einem der Ansprüche 9 bis 15, **dadurch gekennzeichnet, dass** die Haltevorrichtungen (23, 33) derart verschiebbar angeordnet sind, dass das darin eingespannte Substrat (S1, S2) von der Vorkammer (2, 3) über die jeweilige Öffnung (26, 36) in die Behandlungskammer (1) hinein und wieder zurück bewegbar ist.

## Claims

1. Method for the plasma surface treatment of substrates, **characterised by** the following method sequence:
- a first substrate (S1) is plasma-coated in a treatment chamber (1) while at the same time a second substrate (S2) to be subsequently coated is heated and cleaned in a first pre-chamber (2) by means of a first plasmatron (20), wherein the plasmatron is moved during heating and cleaning;
- the first substrate (S1) is thereafter removed from the treatment chamber (1) and the second substrate (S2) is transferred into the treatment chamber (1) and plasma-coated therein by means of a plasma-spraying device (10);
- during the coating of the second substrate (S2) in the treatment chamber (1) a third substrate (S3) is simultaneously heated and cleaned in a second pre-chamber (3) by means of a further plasmatron (30), wherein the plasmatron is moved during heating and cleaning.

2. Method in accordance with claim 1,
**characterised in that**
the second substrate (S2) is switched as a cathode for the cleaning and an arc (25A) is produced which is transferred from the plasmatron (20) onto the substrate (S2).

3. Method in accordance with any one of the preceding claims,
**characterised in that**
an underpressure is produced in the treatment chamber (1) at least during the plasma-coating of a substrate (S1).

4. Method in accordance with any one of the preceding claims,
**characterised in that**
an underpressure is produced in the pre-chamber (2) at least during the pre-treatment of a substrate (S2).

5. Method in accordance with any one of the preceding claims,
**characterised in that**
substrates (S2, S3) which are to be treated one after the other are alternately pre-treated in a first pre-treatment chamber (2) and a second pre-treatment chamber (3) respectively.

6. Method in accordance with any one of the preceding claims,
**characterised in that**
the respective pre-chamber (2, 3) is closed off during the pre-treatment of a substrate (2, 3) both with respect to the environmental atmosphere and also with respect to the treatment chamber (1).

7. Method in accordance with any one of the preceding claims,
**characterised in that**
the substrate (S2, S3) is moved during the pre-treatment.

8. Method in accordance with any one of the preceding claims,
**characterised in that**
the substrate (S1) and/or the plasmatron (10) is moved or are moved during the plasma-coating.

9. Apparatus for carrying out the method in accordance with any one of the preceding claims, including a treatment chamber (1) which can be evacuated with a plasma-spraying device (10) arranged therein and also two pre-chambers (2, 3) for the pre-treatment of a substrate (S1, S2) which is to be subsequently transferred to the treatment chamber (1),
**characterised in that**
two pre-chambers (2, 3) are provided adjoining the treatment chamber (1) which are each connected via a closable opening (26, 36) to the treatment chamber (1) and **in that** a plasmatron (20, 30) is provided which is moveably arranged for the pre-treatment of the substrate (S1, S2) which is subsequently to be coated in the treatment chamber (1) in each pre-chamber (2, 3) and **in that** a holding device (23, 33) for the clamping of the substrate (S1, S2) is associated with each pre-chamber (2, 3).

10. Apparatus in accordance with claim 9,
**characterised in that**
a slide (27, 37) for the closing off of the opening (26, 36) is associated with each pre-chamber (2, 3).

11. Apparatus in accordance with any one of the claims 9 and 10,
**characterised in that**
each pre-chamber (2, 3) is provided with a closable cover (4, 5), with each cover (4, 5) being provided with an opening (6, 7) for the through movement of the holding device (23, 33).

12. Apparatus in accordance with any one of the claims 9 to 11,
**characterised in that**
the holding device(s) (23, 33) is/are made movable in the longitudinal direction and **in that** the respective holding device (23, 33) is movable by at least the length of a pre-chamber (2, 3).

13. Apparatus in accordance with any one of the claims 9 to 12,
**characterised in that**
each holding device (23, 33) is provided at an end with a clamping device (24, 34).

14. Apparatus in accordance with claim 13,
**characterised in that**
at least the clamping device (24, 34) is rotatably formed.

15. Apparatus in accordance with any one of the claims 9 to 14,
**characterised in that**
the pre-chambers (2, 3) lie diametrically opposite to one another.

16. Apparatus in accordance with any one of the claims 9 to 15,
**characterised in that**
the holding devices (23, 33) are so displaceably arranged that the substrate (S1, S2) clamped therein can be moved from the pre-chamber (2, 3) via the respective opening (26, 36) into the treatment chamber (1) and back again.

## Revendications

1. Procédé de traitement de surface de substrats par plasma, **caractérisé par** le déroulement de procédé suivant:
- un premier substrat (S1) est enduit par plasma dans une chambre de traitement (1) pendant que, simultanément, un deuxième substrat (S2) à enduire consécutivement est chauffé et nettoyé dans une première antichambre (2) par un premier plasmatron (20), où le plasmatron est déplacé pendant le chauffage et le nettoyage;
- le premier substrat (S1) est ensuite retiré de la chambre de traitement (1), et le deuxième substrat (S2) est transféré dans la chambre de traitement (1) et y est enduit par plasma au moyen d'un dispositif de projection de plasma (10) ;
- pendant l'enduction du deuxième substrat (S2) dans la chambre de traitement (1), un troisième substrat (S3) est simultanément chauffé et nettoyé dans une deuxième antichambre (3) par un autre plasmatron (30), où le plasmatron est déplacé pendant le chauffage et le nettoyage.

2. Procédé selon la revendication 1, **caractérisé en ce que** le deuxième substrat (S2) est utilisé comme cathode pour le nettoyage et qu'un arc électrique (25A) transféré du plasmatron (20) au substrat (S2), est généré.

3. Procédé selon l'une des revendications précédentes, **caractérisé en ce qu'**une sous-pression est générée dans la chambre de traitement (1), du moins pendant l'enduction par plasma d'un substrat (S1).

4. Procédé selon l'une des revendications précédentes, **caractérisé en ce qu'**une sous-pression est générée dans l'antichambre (2), du moins pendant le prétraitement d'un substrat (S2).

5. Procédé selon l'une des revendications précédentes, **caractérisé en ce que** les substrats à enduire l'un après l'autre (S2, S3) sont prétraités alternativement dans une première ou bien une deuxième antichambre (2, 3).

6. Procédé selon l'une des revendications précédentes, **caractérisé en ce que** chaque antichambre (2, 3) est fermée pendant le prétraitement d'un substrat (2, 3) aussi bien vis à vis de l'atmosphère environnante que vis à vis de la chambre de traitement (1).

7. Procédé selon l'une des revendications précédentes, **caractérisé en ce que** le substrat (S2, S3) est/sont déplacé(s) pendant le prétraitement.

8. Procédé selon l'une des revendications précédentes, **caractérisé en ce que** le substrat (S1) et/ou le plasmatron (10) sont/est déplacé(s) pendant l'enduction par plasma.

9. Système permettant de réaliser le procédé selon l'une des revendications précédentes, avec une chambre de traitement (1) pouvant être évacuée, ayant un dispositif de projection plasma (10) disposé à l'intérieur et deux antichambres (2, 3) pour le prétraitement d'un substrat (S1, S2) devant être amené par la suite à la chambre de traitement (1), **caractérisé en ce que** l'on a prévu deux antichambres (2, 3) adjacentes à la chambre de traitement (1), qui sont reliées à la chambre de traitement (1) par une ouverture refermable (26, 36), **en ce que** dans chaque antichambre (2, 3) est prévu un plasmatron disposé d'une manière mobile (20, 30) pour le prétraitement du substrat (S1, S2) à enduire par la suite dans la chambre de traitement (1), et **en ce que**, à chaque antichambre (2, 3) est attribué un dispositif de support (23, 33) pour le serrage d'un substrat (S1, S2).

10. Système selon la revendication 9, **caractérisé en ce que**, à chaque antichambre (2, 3) est attribuée une coulisse (27, 37) pour la fermeture de l'ouverture (26, 36).

11. Système selon l'une des revendications 9 ou 10, **caractérisé en ce que** chaque antichambre (2, 3) est dotée d'un couvercle (4, 5) pouvant être ôté, chaque couvercle (4, 5) étant doté d'une ouverture (6, 7) pour l'introduction du dispositif de support (23, 33).

12. Système selon l'une des revendications 9 à 11, **caractérisé en ce que** le ou les dispositifs de support (23, 33) sont conçus de manière à être mobiles dans la direction longitudinale et **en ce que** chaque dispositif de support (23, 33) est mobile sur au moins la longueur d'une antichambre (2, 3).

13. Système selon l'une des revendications 9 à 12, **caractérisé en ce que** chaque dispositif de support (23, 33) est doté à l'extrémité d'un dispositif de serrage (24, 34).

14. Système selon la revendication 13, **caractérisé en ce qu'**au moins le dispositif de serrage (24, 34) est conçu de manière à être rotatif.

15. Système selon l'une des revendications 9 à 14, **caractérisé en ce que** les antichambres (2, 3) sont diamétralement opposées.

16. Système selon l'une des revendications 9 à 15, **caractérisé en ce que** les dispositifs de support (23, 33) sont disposés pour pouvoir être glissés de telle manière que le substrat (S1, S2) qui y est serré peut être sorti de l'antichambre (2, 3) en passant par l'ouverture respective (26, 36) et entré dans la chambre de traitement (1) et inversement.
